# EUROPEAN PATENT APPLICATION

(11) **EP 4 383 486 A1**
(43) Date of publication of application: **12.06.2024**
(21) Application number: 23211645.9
(22) Date of filing: 23.11.2023
(51) Int. Cl.: H02B 1/56, H05K 7/20

(54) **ELECTRICAL CABINET, ELECTRICAL CABINET COMBINATION AND ELECTRICAL CABINET WORKING GROUP**

(30) Priority: 08.12.2022 CN 202223286217 U; 14.04.2023 CN 202320880504 U
(71) Applicant: Sungrow Power Supply Co., Ltd., Hefei, Anhui 230088 (CN)
(72) Inventor: PAN, Zhiyuan, Hefei, Anhui (CN); ZHANG, Xianwei, Hefei, Anhui (CN); ZHU, Qiyao, Hefei, Anhui (CN); WANG, Xiaohu, Hefei, Anhui (CN)
(74) Representative: Zacco Norway AS

(57) **Abstract**

The present application discloses an electrical cabinet body unit, an electrical cabinet body combination and an electrical cabinet body working group. The electrical cabinet body unit comprises a main chamber cabinet (11), a side chamber cabinet (12) and a heat exchanger (14). A first installation chamber (111) and a second installation chamber (112) are provided in the main chamber cabinet (11), and a third installation chamber (121) is provided in the side chamber cabinet (12), and the third installation chamber (121) is in communication with the first installation chamber (111) and the second installation chamber (112), respectively. The heat exchanger (14) comprises a first heat-exchanging air duct (141) and a cooler that is configured for cooling the first heat-exchanging air duct (141), wherein one end of the first heat-exchanging air duct (141) is in communication with the first installation chamber (111), and the other end of the first heat-exchanging air duct is in communication with the second installation chamber (112).

## Description

### FIELD

The present application relates to the technical field of an electrical cabinet, in particular to an electrical cabinet body unit, an electrical cabinet body combination and an electrical cabinet body working group.

### BACKGROUND

A photovoltaic grid-connected low-voltage junction cabinet, as an interface device between a tandem inverter system and an electrical power grid, mainly consists of a branch switch and a frame circuit breaker. The branch switch is connected with the AC output of the tandem inverter, and then connected with the frame circuit breaker to realize low-voltage AC power convergence. With the increasing market demand for the tandem inverter, the requirements for the structural design of the low-voltage junction cabinet are becoming increasingly higher, especially in terms of multi-path spatial layout and heat dissipation mode, etc. The common problem of the existing low-voltage junction cabinet is that the heat dissipation channels are chaotic, making it difficult to manage the heat from the internal components of the low-voltage junction cabinet. Similarly, similar problems also exist in other similar electrical cabinets.

In summary, how to solve the problem that the heat dissipation channels of the electrical cabinet are chaotic and complicated, thereby making it difficult to manage the heat from the internal components of the electrical cabinet, has become an urgent technical problem for the skilled person in this field.

### SUMMARY

In view of this, the present application provides an electric cabinet body unit, an electric cabinet body combination and an electric cabinet body working group in order to solve the problem that the heat dissipation channels of the electric cabinet is chaotic and complicated, thereby making it difficult to manage the heat from the internal components of the electric cabinet.

In order to achieve the above object, the following technical solutions are provided according to the present application.

An electrical cabinet body unit includes a main chamber cabinet, a side chamber cabinet and a heat exchanger, where the side chamber cabinet is arranged at one side of the main chamber cabinet.

A first installation chamber and a second installation chamber are sequentially provided in the main chamber cabinet from top to bottom, and a third installation chamber is provided in the side chamber cabinet, where the third installation chamber is in communication with the first installation chamber and the second installation chamber, respectively.

A heat exchanger is provided on a cabinet wall of the electrical cabinet body unit, and the heat exchanger includes a first heat-exchanging air duct and a cooler that is configured for cooling the first heat-exchanging air duct, where one end of the first heat-exchanging air duct is in communication with the first installation cavity, and another end of the first heat-exchanging air duct is in communication with the second installation cavity.

Wherein the first installation cavity, the first heat-exchanging air duct, the second installation chamber and the third installation chamber are circularly in communication in sequence so as to form a circulation air duct that serves as an internal circulation air duct, and an internal circulation fan is provided in the internal circulation air duct.

In an embodiment, the internal circulation fan includes a first circulation fan that is installed in the first heat-exchanging air duct. And a circulation direction of an airflow provided by the first circulation fan is a flow direction of an airflow being sucked into the first heat-exchanging air duct from the first installation cavity.

In an embodiment, both ends of the first heat-exchanging air duct are an air outlet end and an air return end, respectively, where the air return end is in communication with the first installation cavity, and the air outlet end is in communication with the second installation cavity, and the first circulation fan is installed at the air return end and arranged towards the components that are installed in the first installation cavity.

In an embodiment, the internal circulation fan further includes a second circulation fan that is provided in the second installation cavity. And a circulation direction of an airflow provided by the second circulation fan is the flow direction of the airflow being blown into the third installation chamber from the second installation cavity.

In an embodiment, a first insulating plate is sandwiched between the first installation chamber and the second installation cavity, and a second insulating plate is sandwiched between the first installation chamber and the third installation chamber as well as between the second installation chamber and the third installation cavity, respectively.

In an embodiment, the cooler includes a heat transfer component, a second heat-exchanging air duct, and an external circulation fan installed in the second heat-exchanging air duct, where the heat transfer component is used to transfer the heat from the first heat-exchanging air duct to the second heat-exchanging air duct. And an air inlet of the second heat-exchanging air duct and an air outlet of the second heat-exchanging air duct are both in communication with the external environment so as to form an external circulation air duct, and the external circulation fan serves to provide airflow circulation power for the second heat-exchanging air duct.

In an embodiment, the air inlet and the air outlet of the second heat-exchanging air duct are arranged on the outer wall surface of the heat exchanger from top to bottom.

In an embodiment, the airflow direction of the first heat-exchanging air duct is arranged in the opposite direction to the airflow direction of the second heat-exchanging air duct.

In an embodiment, the first installation chamber is used for installing a circuit breaker assembly, the second installation chamber is used for installing a first isolation switch assembly, and the third installation chamber is used for installing a second isolation switch assembly and its accessory components.

In an embodiment, the cabinet wall of the electrical cabinet body unit is a unit cabinet door, where the heat exchanger is located on the cabinet wall of the electrical cabinet body unit.

In an embodiment, the unit cabinet door includes a first door body and a second door body, where the first door body covers a front side of the main chamber cabinet and a front side of the side chamber cabinet in an openable and closable manner, and the second door body covers a side, facing away from the side chamber cabinet, of the main chamber cabinet in an openable and closable manner. Alternatively, the second door body covers a side, facing away from the main chamber cabinet, of the side chamber cabinet in an openable and closable manner, the heat exchanger is provided on the first door body or on the second door body.

Compared with the introduction to the arts in Background, the above-mentioned electrical cabinet body unit includes a main chamber cabinet, a side chamber cabinet and a heat exchanger, where the side chamber cabinet is arranged at one side of the main chamber cabinet. A first installation chamber and a second installation chamber are sequentially arranged from top to bottom in the main chamber cabinet, and a third installation chamber is provided in the side chamber cabinet, where the third installation chamber is in communication with the first installation chamber and the second installation chamber, respectively. The heat exchanger is provided on a cabinet wall of the electrical cabinet body unit, and the heat exchanger includes a first heat-exchanging air duct and a cooler that is configured for cooling the first heat-exchanging air duct, where one end of the first heat-exchanging air duct is in communication with the first installation cavity, and the other end of the first heat-exchanging air duct is in communication with the second installation cavity. The first installation cavity, the first heat-exchanging air duct, the second installation chamber and the third installation chamber are circularly in communication in sequence so as to form a circulation air duct that serves as an internal circulation air duct, and an internal circulation fan is provided in the internal circulation air duct. In the actual use, the first installation chamber and the second installation chamber in the main chamber cabinet are in communication through the first heat-exchanging air duct, and the third installation chamber is in communication with the first installation chamber and the second installation chamber, respectively. Hence, the first installation cavity, the first heat-exchanging air duct, the second installation chamber and the third installation chamber are circularly communicated in sequence to form a circulation air duct, which constitutes an internal circulation air duct of the electrical cabinet body unit. The first heat-exchanging air duct can be cooled by the cooler of the heat exchanger, and thus the electrical cabinet body unit of the above structure can meet the heat dissipation requirement through the internal circulation air duct in cooperation with the cooler. Meanwhile, the fluid in the internal circulation air duct flows independently from the external airflow of the electrical cabinet body unit, making the heat dissipation channels more regular. In addition, the components with a main heat generation amount in the main chamber cabinet are installed in the first installation chamber and the second installation chamber, respectively, and the components with a main heat generation amount in the side chamber cabinet are installed within the third installation cavity, and the whole internal circulation air duct is cooled and heat dissipated through the cooler of the heat exchanger, which facilitates of the thermal management for the internal components of the electrical cabinet body.

In addition, the present application further provides an electrical cabinet body combination, including two electrical cabinet body units described in any of the above embodiments, where the two electrical cabinet body units are split jointed in a symmetrical arrangement on a side, facing away from the side chamber cabinet, of the main chamber cabinet, and in case that the unit cabinet door includes a second door body, the second door body covers a side, facing away from the main chamber cabinet, of the side chamber cabinet in an openable and closable manner. Alternatively, the two electrical cabinet body units are split jointed in a symmetrical arrangement on a side, facing away from the main chamber cabinet, of the side chamber cabinet, and in case that the unit cabinet door includes a second door body, the second body door covers a face, facing away from the side chamber cabinet, of the main chamber cabinet body 11 in an openable and closable manner. Due to the aforementioned technical effects of the electrical cabinet body unit, the electrical cabinet body combination including the above electrical cabinet body unit should also have corresponding technical effects, and therefore it will not repeat here.

The present application further provides an electrical cabinet combination, including two electrical cabinet body units described in any of the above embodiments, where the two electrical cabinet body units are split jointed in a manner that the back sides thereof are arranged in opposite and symmetrical.

The present application further provides an electrical cabinet body combination, including two electrical cabinet body units described in any of the above embodiments, where the two electrical cabinet body units are split jointed in a symmetrical arrangement on a side, facing away from the side chamber cabinet, of the main chamber cabinet.

In addition, the present application further provides an electrical cabinet body working group, including at least two electrical cabinet body combinations described in the above embodiments, where two adjacent electrical cabinet body combinations are split jointed on a side, facing away from the main chamber cabinet, of the side chamber cabinet. The unit cabinet door of the electrical cabinet body unit includes a first door, which covers a front side of the main chamber cabinet and a front side of the side chamber cabinet in an openable and closable manner. In addition, the heat exchanger of the electrical cabinet body unit is provided on the first door body.

### BRIEF DESCRIPTION OF THE DRAWINGS

For more clearly illustrating the technical solutions in the embodiments of the present application or the conventional technology, accompanying drawings referred to for describing the embodiments or the conventional technology will be briefly described hereinafter. Apparently, the accompanying drawings in the following description are only some embodiments of the present application, and for the person skilled in the art, other accompanying drawings may be obtained based on the provided drawings without any creative efforts.

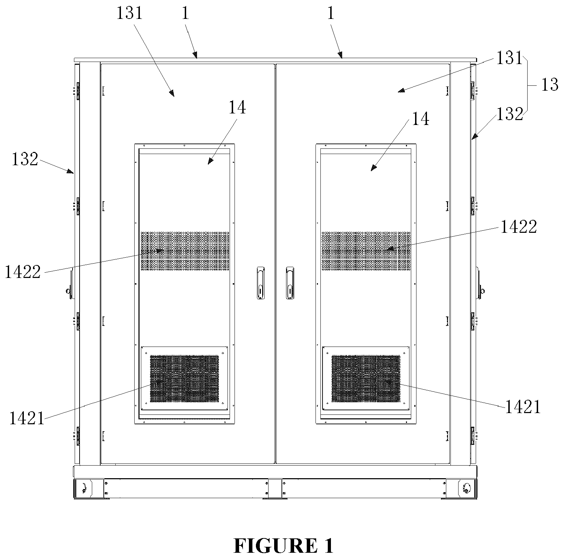

Figure 1 is a schematic front view of the structure of an electrical cabinet body combination provided according to an embodiment of the present application (in the figure, two electrical cabinet body units are split jointed on a side, facing away from a side chamber cabinet, of a main chamber cabinet);

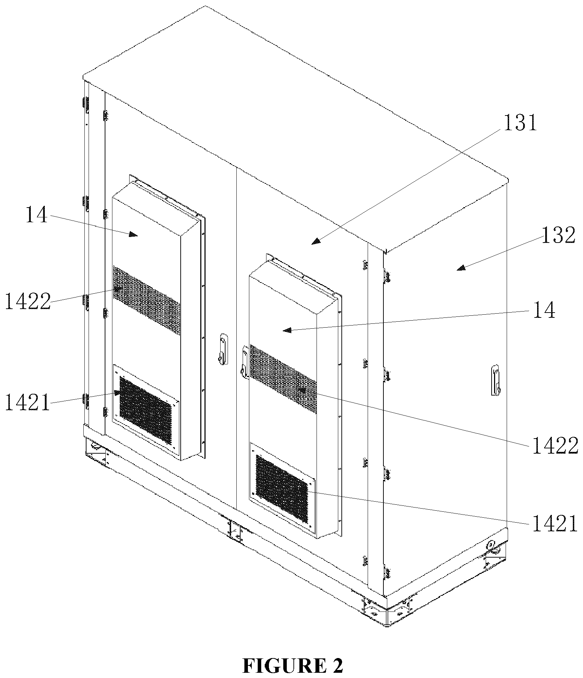

Figure 2 is a schematic isometric view of the structure of the electrical cabinet body combination provided according to the embodiment of the present application (in the illustration, the two electrical cabinet body units are split jointed on the side, facing away from the side chamber cabinet, of the main chamber cabinet);

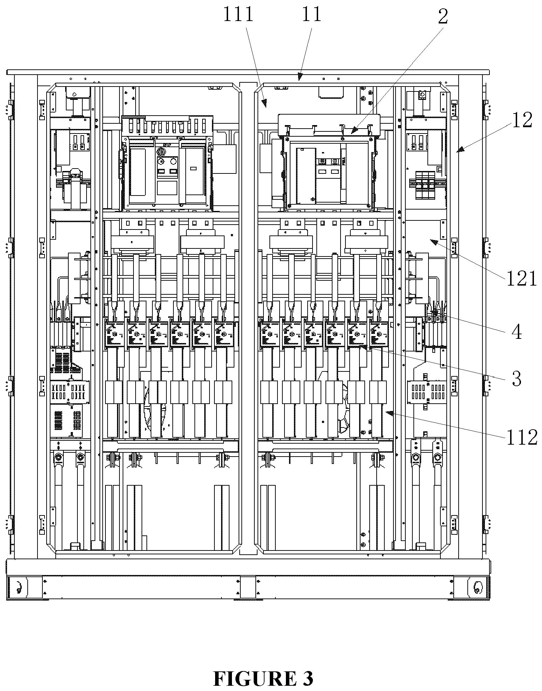

Figure 3 is a schematic view in the front perspective of the structure inside the electrical cabinet body combination provided according to the embodiment of the present application (in this figure, the two electrical cabinet body units are split jointed on the side, facing away from the side chamber cabinet, of the main chamber cabinet);

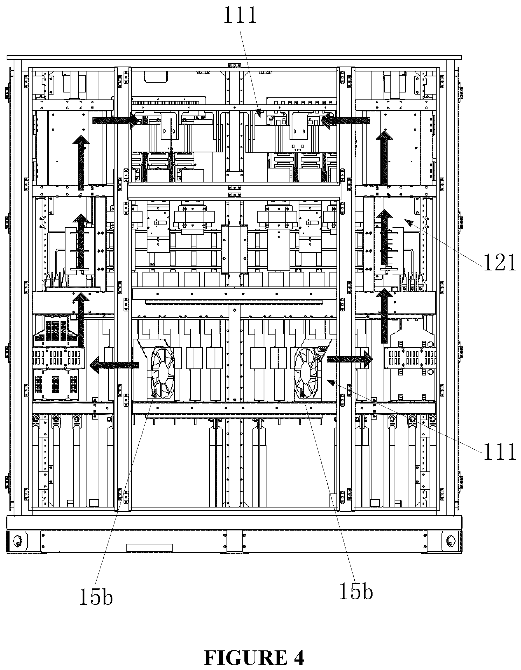

Figure 4 is a structural schematic view of the internal circulation air duct in the electrical cabinet body combination provided according to the embodiment of the present application (in this figure, the two electrical cabinet body units are split jointed on the side, facing away from the side chamber cabinet, of the main chamber cabinet, and the solid arrow represents the circulation direction of airflow).

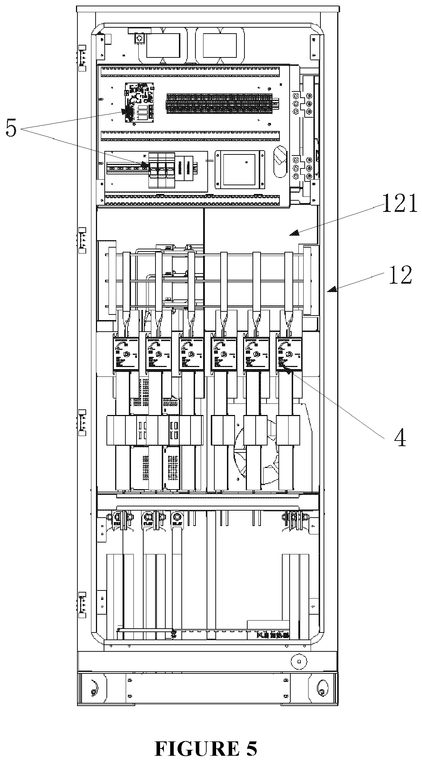

Figure 5 is a structural schematic view of the electrical cabinet body combination provided according to the embodiment of the present application from left perspective (in this figure, the two electrical cabinet body units are split jointed on the side, facing away from the side chamber cabinet, of the main chamber cabinet);

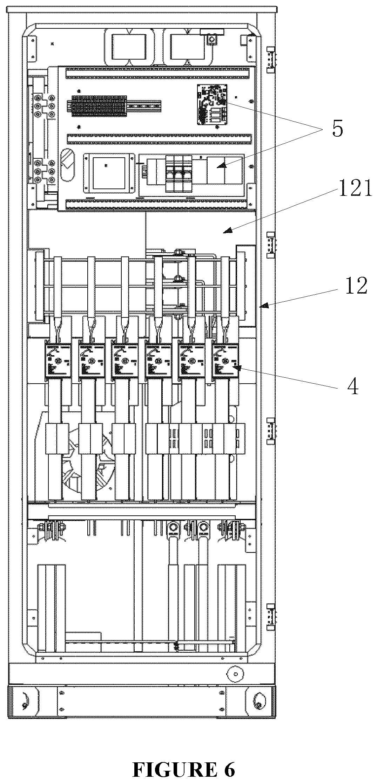

Figure 6 is a structural schematic view of the electrical cabinet body combination provided according to the embodiment of the present application from right perspective (in this figure, the two electrical cabinet body units are split jointed on the side, facing away from the side chamber cabinet, of the main chamber cabinet);

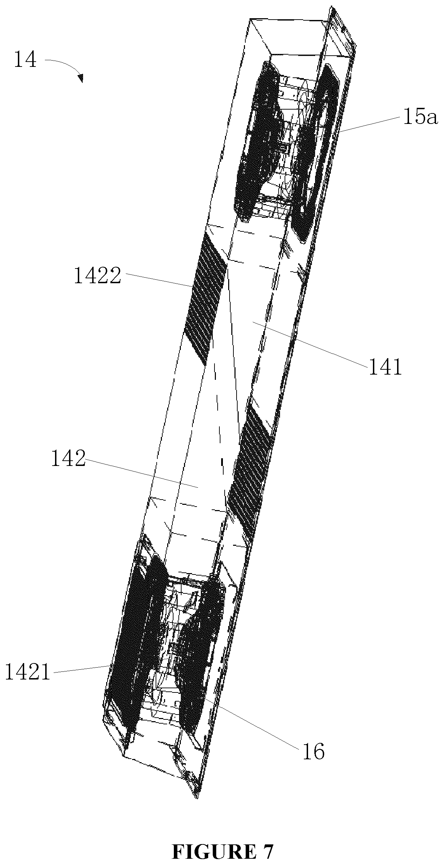

Figure 7 is a structural schematic view of a first heat-exchanging air duct and a second heat-exchanging air duct in a heat exchanger provided according to the embodiment of the present application

### Reference numerals in FIG.1-FIG.7 are as follows:

| | | | |
|---|---|---|---|
| 1. | electrical cabinet body unit; | 11. | main chamber cabinet, |
| 111. | first installation cavity; | 112. | second installation cavity; |
| 12. | side chamber cabinet; | 121. | third installation cavity, |
| 13. | unit cabinet door ; | 131. | first door body; |
| 132. | second door body; | 14. | heat exchanger; |
| 141. | first heat-exchanging air duct; | 142. | second heat-exchanging air duct; |
| 1421. | air inlet; | 1422. | air outlet; |
| 15a. | first circulation fan; | 15b. | second circulation fan; |
| 2. | circuit breaker assembly; | 3. | first isolation switch assembly; |
| 4. | second isolation switch assembly; | 5. | accessory component. |

### DETAILED DESCRIPTION OF EMBODIMENTS

The core of this present application is to provide an electrical cabinet body unit, an electrical cabinet body combination and an electrical cabinet body working group, in order to solve the problem that the heat dissipation channels of the electrical cabinet body are chaotic and complicated, making it difficult to manage the heat from the internal components of the electrical cabinet.

The technical solutions in the embodiments of the present utility mode will be described clearly and completely as follows in conjunction with the accompanying drawings in the embodiments of the present utility mode. It is apparent that the described embodiments are only a part of the embodiments according to the present utility mode, rather than all of the embodiments. All the other embodiments obtained by those skilled in the art based on the embodiments of the present utility mode without creative work will fall within the scope of protection of the present utility mode.

Referring to Figures 1 to 7, as shown, an electric cabinet body unit is specifically provided according to the present application. The electric cabinet body unit includes a main chamber cabinet 11, a side chamber cabinet 12 that is arranged on one side of the main chamber cabinet 11, and a heat exchanger 14. A first installation chamber 111 and a second installation chamber 112 are sequentially arranged in the main chamber cabinet 11 from top to bottom, and a third installation chamber 121 is provided in the side chamber cabinet 12, where the third installation chamber 121 is in communication with the first installation chamber 111 and the second installation chamber 112, respectively. The heat exchanger 14 is provided on a cabinet wall of the electrical cabinet body unit 1, and the heat exchanger 14 includes a first heat-exchanging air duct 141 and a cooler that is configured for cooling the first heat-exchanging air duct 141, where one end of the first heat-exchanging air duct 141 is in communication with the first installation chamber 111, and the other end of the first heat-exchanging air duct 141 is in communication with the second installation chamber 112. Herein, the first installation chamber 111, the first heat-exchanging air duct, the second installation chamber 112 and the third installation chamber 121 are circularly in communication in sequence so as to form a circulation air duct that serves as an internal circulation air duct, and an internal circulation fan is provided in the internal circulation air duct.

In the actual application of the electrical cabinet body unit, referring to Fig. 1 to Figure 4 and Figure 7, the first installation chamber 111 and the second installation chamber 112 in the main chamber cabinet 11 are in communication through the first heat-exchanging air duct 141, and the third installation chamber 121 is in communication with the first installation chamber 111 and the second installation chamber 112, respectively, so that the first installation chamber 111, the first heat-exchanging air duct 141, the second installation chamber 112 and the third installation chamber 112 are circularly in communication in sequence to form a circulation air duct that is configured as an internal circulation air duct of the electrical cabinet body unit. The cooler of the heat exchanger 14 is able to cool the first heat-exchanging air duct 141, and thus the electrical cabinet body unit 1 of the above structure can meet the heat dissipation requirement through the internal circulation air duct in cooperation with the cooler. Meanwhile, the fluid in the internal circulation air duct flows independently from the external airflow of the electrical cabinet body unit 1, making the heat dissipation channels more regular. In addition, the components with a main heat generation amount in the main chamber cabinet 11 are installed in the first installation chamber 111 and the second installation chamber 112, respectively, and the components with a main heat generation amount in the side chamber cabinet 12 are installed within the third installation chamber 121. The whole internal circulation air duct is cooled and heat-dissipated through the cooler of the heat exchanger 14, which more facilitates the thermal management for the internal components of the electrical cabinet body.

It should be noted that the internal circulation fan is used to provide airflow circulation power for the internal circulation air duct. Specifically, an axial-flow fan or other types of fans can be used, and no more specific restrictions will be made here. The airflow circulation direction of the internal circulation air duct may be as follows: the airflow from the first installation chamber 111 flows into the first heat-exchanging air duct 141, then flows into the second installation chamber 112, then flows into the third installation chamber 121, and then flows back to the first installation chamber 111 from the third installation chamber 121. Alternatively, the airflow from the second installation chamber 112 flows into the first heat-exchanging air duct 141, then flows into the first installation chamber 111 from the first heat-exchanging air duct 141, then flows into the third installation chamber 121 from the first installation chamber 111, and then flows back to the second installation chamber 112 from the third installation chamber 121. In the actual application, it can be selected according to the actual demands.

In should be further noted that the cooler of the heat exchanger 14 mentioned above can be either in an air-cooling heat exchange mode or in the form of other cooler structures commonly used by those skilled in the technical art, such as in a liquid-cooling mode, etc. Taking the air-cooling heat exchange mode as an example, the cooler can specifically include a heat transfer component, a second heat-exchanging air duct 142, and an external circulation fan 16 installed in the second heat-exchanging air duct 142, where the heat transfer component is used for transferring the heat from the first heat-exchanging air duct 141 to the second heat-exchanging air duct 142. And an air inlet 1421 of the second heat-exchanging air duct 142 and an air outlet 1422 of the second heat-exchanging air duct 142 are both in communication with the external environment to form an external circulation air duct, where the external circulation fan 16 serves to provide airflow circulation power for the second heat-exchanging air duct 142. Herein, the heat transfer component can be specifically realized by means of heat-exchanging aluminum plates or other heat-exchanging components commonly used by those skilled in the technical art, and no more specific restrictions will be made here. Compared with the liquid-cooling mode, the above air cooling heat exchange mode can make full use of the external environment temperature without additional cold sources, and has a simpler structure.

In some specific embodiments, the air circulation direction provided by the above external circulation fan 16 for the second heat-exchanging air duct 142 can be selected and arranged according to actual demands. For example, the air inlet 1421 and the air outlet 1422 of the second heat-exchanging air duct 142 can be arranged on an outer wall surface of the heat exchanger 14 from top to bottom. Specifically, referring to Figure 1 and Figure 2, the air inlet 1421 is arranged below the air outlet 1422, that is, the external circulation air duct adopts a bottom-up circulation mode. Of course, it can be understood that the air inlet 1421 can also be arranged above the air outlet 1422 to form a top-down circulation mode, or a left-to-right and right-to-left circulation mode. In the actual application, the layout can be selected according to actual demands, and no more specific restrictions will be made here.

In other specific embodiments, preferably, the airflow direction of the first heat-exchanging air duct 141 is in opposite with the airflow direction of the second heat-exchanging air duct 142. Countercurrent heat exchange can be realized through the design of such opposite flow arrangements, thereby facilitating of improving the heat exchange efficiency.

In some more specific embodiments, referring to Figure 4 together with Figure 7, the above-mentioned internal circulation fan may specifically include a first circulation fan 15a that is installed in the first heat-exchanging air duct 141, and a circulation direction of an airflow provided by the first circulation fan 15a is the flow direction of the airflow being sucked into the first heat-exchanging air duct 141 from the first installation chamber 111. In that case, the airflow direction of the internal circulation air duct is that the airflow from the first installation chamber 111 flows into the first heat-exchanging air duct 141, then flows into the second installation chamber 112, then flows into the third installation chamber 121, and then flows back to the first installation chamber 111 from the third installation chamber 121. With the first circulation fan 15a being installed in the first heat-exchanging air duct 141, it can ensure that the airflow in the inner circulation air duct can steadily flow through the first heat-exchanging air duct 141, and thereby achieving stable heat exchange with the cooler and having a better heat dissipation effect.

In a further embodiment, referring to Figure 4 together with Figure 7, two ends of the above first heat-exchanging air duct 141 are respectively an air outlet end and an air return end, where the air return end is in communication with the first installation chamber 111, and the air outlet end is in communication with the second installation chamber 112, and the first circulation fan 15a is installed at the air return end and arranged towards the components that are installed in the first installation chamber 111, so that the heat from the components installed in the first installation chamber 111 can be dissipated more timely, ensuring the timeliness of heat dissipation.

In some specific embodiments, referring to Figure 4, the internal circulation fan may further include a second circulation fan 15b that is provided in the second installation chamber 112, and a circulation direction of an airflow provided by the second circulation fan 15b is the flow direction of the airflow being blown into the third installation chamber 121 from the second installation chamber 112. By provision of the second circulation fan 15b, the cold airflow flowing from the first heat-exchanging air duct 141 into the second installation chamber 112 can quickly flow to the third installation chamber 121, effectively avoiding the problem of poor heat dissipation caused by the accumulation of the cold airflow in the second installation chamber 112. The circulating heat dissipation capacity of the inner circulation air duct can be greatly improved by cooperation of the first circulation fan 15a and the second circulation fan 15b.

In some specific embodiments, a first insulating plate is sandwiched between the first installation chamber 111 and the second installation chamber 112, while a second insulating plate is respectively sandwiched between the first installation chamber 111 and the third installation chamber 121, as well as between the second installation chamber 112 and the third installation chamber 121. The electrical insulation of components installed in each installation chamber can be improved by provision of the first insulating plate and the second insulating plate. It should be noted that those skilled in the technical field should understand that the second insulating plate should not affect the communication between the third installation chamber 121 and the first installation chamber 111 as well as the second installation chamber 112.

In some more specific embodiments, the above-mentioned electrical cabinet body unit 1 can be a low-voltage junction cabinet. In that case, a circuit breaker assembly 2 can be installed in the corresponding first installation chamber 111, a first isolation switch assembly 3 can be installed in the second installation chamber 112, and a second isolation switch assembly 4 and its accessory components 5 can be installed in the third installation chamber 121, this is because that the circuit breaker assembly 2, isolation switch assembly (i.e., the first isolation switch assembly 3 and the second isolation switch assembly 4) and accessory components 5 thereof are all components with relatively heat generation in the low-voltage junction cabinet. The accessory component may be a temperature control module, a metering module, etc. Of course, it can be understood that the electric cabinet body unit 1 can be applied not only to a low-voltage junction cabinet, but also in situations of other electrical cabinet body, and no more specific restrictions will be made here.

In other specific embodiments, preferably, the cabinet wall of the electrical cabinet body unit 1 is a unit cabinet door 13, where the heat exchanger 14 is located in the cabinet wall of the electrical cabinet body unit 1. By provision of the heat exchanger 14 in the unit cabinet door 13, it can further facilitate of installation and maintenance of the heat exchanger.

In a further embodiment, the above unit cabinet door 13 may specifically include a first door body 131 and a second door body 132, where the first door body 131 covers a front side of the main chamber cabinet 11 and a front side of the side chamber cabinet 12 in an openable and closable manner, and the second door body 132 covers a side, facing away from the side chamber cabinet 12, of the main chamber cabinet 11 in an openable and closable manner. Alternatively, the second door body 132 covers a face, facing away from the main chamber cabinet 11, of the side chamber cabinet 12 in an openable and closable manner. Herein, the heat exchanger 14 is provided on the first door body 131 or the second door body 132. With configuration of the unit cabinet door 13 of the electrical cabinet body unit 1 in the structure of the first door body 131 and the second door body 132 mentioned above, the electrical cabinet body unit 1 has multiple maintenance and operation interfaces, making it more convenient for a user to operate in different areas, thereby improving the convenience of operation. For example, when the second door body 132 of the corresponding side chamber cabinet 12 is open, its internal components (such as voltage transformer, axial-flow fan, lightning protection component, etc.) can be maintained and replaced. Specifically, the opening and closing of the first door body 131 and the second door body 132 can be realized in a hinged door structure, or in other structural forms commonly used by those skilled in the technical field, and no more specific restrictions will be made here.

In addition, the present application further provides an electric cabinet body combination, specifically including two electric cabinet body units 1 described in any one of the above embodiments. The two electrical cabinet body units 1 are split jointed in a symmetrical arrangement on a side, facing away from the side chamber cabinet 12, of the main chamber cabinet 11, and in case that the unit cabinet door 13 includes a second door body 132, the second door body 132 covers a side, facing away from the main chamber cabinet 11, of the side chamber cabinet 12 in an openable and closable manner. Alternatively, the two electrical cabinet body units 1 are split jointed in a symmetrical arrangement on a side, facing away from the main chamber cabinet 11, of the side chamber cabinet 12, and in case that the unit cabinet door 13 includes a second door body 132, the second door body 132 covers a side, facing away from the side chamber cabinet 12, of the main chamber cabinet body 11 in an openable and closable manner. Due to the aforementioned technical effects of the electrical cabinet body unit, the electrical cabinet body combination including the above electrical cabinet body unit should also have corresponding technical effects, and therefore it will not repeat here.

The present application further provides an electrical cabinet body combination, including two electrical cabinet body units 1 described in the above embodiments, where the two electrical cabinet body units 1 are split jointed in a manner that the back sides thereof are arranged in opposite and symmetrical. With this structure, the unit cabinet door 13 can specifically include a first door body 131 and a second door body 132, where the first door body 131 covers a front side of the main chamber cabinet 11 and a front side of the side chamber cabinet 12 in an openable and closable manner, and the second door body 132 covers a face, facing away from the side chamber cabinet 12, of the main chamber cabinet 11 in an openable and closable manner, and the second door body 132 can also cover a side, facing away from the main chamber cabinet 11, of the side chamber cabinet 12 in an openable and closable manner. Herein, the heat exchanger 14 is arranged on the first door body 131 or the second door body 132. With the design of the above structure, the electrical cabinet body can realize integrated management, and the specific arrangement of the unit cabinet door 13 of each electrical cabinet body unit 1 is not affected.

In addition, the present application further provides another electrical cabinet body combination, including two electrical cabinet body units 1 described in the above embodiments, where the two electrical cabinet body units 1 are split jointed in a symmetrical arrangement on a side, facing away from the side chamber cabinet 12, of the main chamber cabinet 11. In that case, the electrical cabinet body unit 1 in the corresponding electrical cabinet body combination is generally only provided with the first door 131, so the purpose of this configuration is to facilitate the subsequent reassembly of various electrical cabinet body combinations in order to form a working group.

Specifically, the present application further provides an electrical cabinet body working group, where two adjacent electrical cabinet body combinations are split jointed on a side, facing away from the main chamber cabinet 11, of the side chamber cabinet 12. The unit cabinet door 13 of the electrical cabinet body unit 1 includes a first door 131 that covers a front side of the main chamber cabinet 11 and a front side of the side chamber cabinet 12 in an openable and closable manner. In addition, the heat exchanger 14 of the electrical cabinet body unit 1 is provided on the first door body 131.

For example, the structural layout of the entire electrical cabinet body (6400KW) is in a set that can be split into two subsets so as to improve the overall power level. The subset can be in a dual-cabinets combination of two cabinets so as to form a "X-3200" ("3200" refers to the power value) combination, or it can be in one cabinet, and the overall layout inside the cabinet is "a main chamber cabinet + a side chamber cabinet +...". Alternatively, the structure layout of the entire electrical cabinet body is in a set that can be split into multiple subsets. For example, those in 4800KW/8800KW can each be arranged symmetrically and equally, and is split into single cabinet of 2-2400 and 2.4400. This layout can improve the power density, facilitate maintenance and shorten the later maintenance time.

It should be noted that various embodiment in this specification are described in a progressive manner. Each of the embodiments is mainly focused on describing its differences from other embodiments, and references may be made among these embodiments with respect to the same or similar portions among these embodiments.

It should be understood that if "system", "device", "unit" and/or "module" are used herein, it is merely a method for distinguishing different assemblies, elements, components, portions or assembly at different levels. However, if other words serve the same object, they may be replaced by other expressions.

As shown in the present application and the claims, the words "a", "one", "one type" and/or "this" are not specifically referring to the singular, but may also include the plural, unless the context clearly indicates exceptions. Generally speaking, the terms "include" and "comprise" only indicate that the steps and elements that have been clearly identified are included, and these steps and elements do not constitute an exclusive list. A Method or an apparatus may also contain other steps or elements. The elements limited by the statement "comprising (including) a..." do not exclude the existence of other identical elements exist in the process, method, product or apparatus that includes the elements.

In the description of the embodiments of the present application, unless otherwise specified, "/" means or, for example, A/B can mean A or B; the "and/or" herein is only an association relationship that describes the associated objects, which means that there can be three kinds of relationships, for example, A and/or B means that there are three cases: A alone, A and B at the same time, and B alone. In addition, in the description of the embodiments of the present application, "multiple" refers to two or more.

In the following, the terms "first", "second" and the like are only for purpose of description, and should not be interpreted as indicating or implying relative importance or implying the number of the indicated technical features. Therefore, the features defined by "first" and "second" may explicitly or implicitly include one or more of the features.

If a flowchart is used in the present application, the flowchart is used to explain the operation performed by the system according to the embodiment of the present application. It should be understood that the preceding or subsequent operations are not necessarily performed accurately in sequence. Instead, the steps can be processed in reverse order or simultaneously. In addition, other operations can be added to these procedures, or one or more operations can be removed from these procedures.

The principle and embodiments of the present application are described through specific examples herein. The description of the above-described embodiments is merely used to facilitate understanding the core idea of the present application. It should be noted that, for those skilled in the technical field, various improvements and modifications may be further made to the present application without departing from the principle of the present application, and these improvements and modifications also fall within the protection scope defined by the claims of the present application.

## Claims

1. An electrical cabinet body unit, wherein comprising a main chamber cabinet (11), a side chamber cabinet (12) and a heat exchanger (14), the side chamber cabinet (12) is arranged on one side of the main chamber cabinet (11);
a first installation chamber (111) and a second installation chamber (112) are sequentially provided in the main chamber cabinet (11) from top to bottom, and a third installation chamber (121) is provided in the side chamber cabinet (12), wherein the third installation chamber (121) is in communication with the first installation chamber (111) and the second installation chamber (112), respectively;
the heat exchanger (14) is provided on a cabinet wall of the electrical cabinet body unit (1), and the heat exchanger (14) comprises a first heat-exchanging air duct (141) and a cooler that is configured for cooling the first heat-exchanging air duct (141), wherein one end of the first heat-exchanging air duct (141) is in communication with the first installation chamber (111), and the other end of the first heat-exchanging air duct (141) is in communication with the second installation chamber (112);
wherein, the first installation chamber (111), the first heat-exchanging air duct (141), the second installation chamber (112) and the third installation chamber (121) are circularly in communication in sequence so as to form a circulation air duct that serves as an internal circulation air duct, and an internal circulation fan is provided in the internal circulation air duct.

2. The electrical cabinet body unit according to claim 1, wherein the internal circulation fan comprises a first circulation fan (15a) that is installed in the first heat-exchanging air duct (141), and a circulation direction of an airflow provided by the first circulation fan (15a) is a flow direction of an airflow being sucked into the first heat-exchanging air duct (141) from the first installation chamber (111).

3. The electrical cabinet body unit according to claim 2, wherein both ends of the first heat-exchanging air duct (141) are an air outlet end and an air return end, respectively, and the air return end is in communication with the first installation chamber (111), and the air outlet end is in communication with the second installation chamber (112), and the first circulation fan (15a) is installed at the air return end and arranged towards the components that are installed in the first installation chamber (111).

4. The electrical cabinet body unit according to claim 2, wherein the internal circulation fan further comprises a second circulation fan (15b) that is provided in the second installation chamber (112), and a circulation direction of an airflow provided by the second circulation fan (15b) is a flow direction of the airflow being blown into the third installation chamber (121) from the second installation chamber (112).

5. The electrical cabinet body unit according to claim 1, wherein a first insulating plate is sandwiched between the first installation chamber (111) and the second installation chamber (112), and a second insulating plate is sandwiched between the first installation chamber (111) and the third installation chamber (121), as well as between the second installation chamber (112) and the third installation chamber (121), respectively.

6. The electrical cabinet body unit according to claim 1, wherein the cooler comprises a heat transfer component, a second heat-exchanging air duct (142), and an external circulation fan (16) installed in the second heat-exchanging air duct (142),
wherein the heat transfer component is configured for transferring the heat from the first heat-exchanging air duct (141) to the second heat-exchanging air duct (142), and an air inlet (1421) of the second heat-exchanging air duct (142) and an air outlet (1422) of the second heat-exchanging air duct (142) are both in communication with the external environment so as to form an external circulation air duct, wherein the external circulation fan (16) is configured to provide airflow circulation power for the second heat-exchanging air duct (142).

7. The electrical cabinet body unit according to claim 6, wherein the air inlet (1421) and the air outlet (1422) of the second heat-exchanging air duct (142) are arranged on an outer wall surface of the heat exchanger (14) from top to bottom.

8. The electrical cabinet body unit according to claim 6, wherein the airflow direction of the first heat-exchanging air duct (141) is in an opposite arrangement with the airflow direction of the second heat-exchanging air duct (142).

9. The electrical cabinet body unit according to claim 1, wherein the first installation chamber (111) is used for installing a circuit breaker assembly (2), the second installation chamber (112) is used for installing a first isolation switch assembly (3), and the third installation chamber (121) is used for installing a second isolation switch assembly (4) and its accessory components (5).

10. The electrical cabinet body unit according to claim 1, wherein the cabinet wall of the electrical cabinet body unit (1) on which the heat exchanger (14) is located is a unit cabinet door (13).

11. The electrical cabinet body unit according to claim 10, wherein the unit cabinet door (13) comprises a first door body (131) and a second door body (132), the first door body (131) covers a front side of the main chamber cabinet (11) and a front side of the side chamber cabinet (12) in an openable and closable manner, and the second door body (132) covers a side, facing away from the side chamber cabinet (12), of the main chamber cabinet (11) , and/or a side, facing away from the main chamber cabinet (11), of the side chamber cabinet (12) in an openable and closable manner;
wherein, the heat exchanger (14) is provided on the first door body (131) or on the second door body (132).

12. An electrical cabinet body combination, wherein comprising two electrical cabinet body units (1) according to any one of claims 1 to 11;
the two electrical cabinet body units (1) are split jointed in a symmetrical arrangement on a side, facing away from the side chamber cabinet (12), of the main chamber cabinet (11), and in case the unit cabinet door (13) includes a second door body (132), the second door body (132) covers a side, facing away from the main chamber cabinet (11), of the side chamber cabinet (12) in an openable and closable manner; or
the two electrical cabinet body units (1) are split jointed in a symmetrical arrangement on a side, facing away from the main chamber cabinet (11), of the side chamber cabinet (12), and in case that the unit cabinet door (13) includes a second door body (132), the second door body (132) covers a side, facing away from the side chamber cabinet (12), of the main chamber cabinet body (11) in an openable and closable manner.

13. An electrical cabinet body combination, wherein comprising two electrical cabinet body units (1) according to any one of claims 1 to 11, wherein the two electrical cabinet body units (1) are split jointed in a manner that the back sides thereof are arranged in opposite and symmetrical.

14. An electrical cabinet body combination, wherein comprising at least two electrical cabinet body units (1) according to any one of claims 1-11, and the two electrical cabinet body units (1) are split jointed in a symmetrical arrangement on a side, facing away from the side chamber cabinet (12), of the main chamber cabinet (11).

15. An electrical cabinet body working group, wherein comprising at least two electrical cabinet body combinations according to claim 14, wherein two adjacent electrical cabinet body combinations are split jointed on a side, facing away from the main chamber cabinet (11), of the side chamber cabinet (12), and the unit cabinet door (13) of the electrical cabinet body unit (1) comprises a first door body(131), the first door body(131) covers a front side of the main chamber cabinet (11) and a front side of the side chamber cabinet (12) in an openable and closable manner,
wherein the heat exchanger (14) of the electrical cabinet body unit (1) is provided on the first door body (131).
